Europäisches Patentamt

European Patent Office

Office européen des brevets

(19)

(11) Publication number: **0 025 273**
**B1**

(12) # EUROPEAN PATENT SPECIFICATION

(45) Date of publication of patent specification: **20.06.84**

(51) Int. Cl.³: **G 11 C 11/24**

(21) Application number: **80302701.0**

(22) Date of filing: **07.08.80**

(54) Semiconductor refresh circuit in dynamic random access memory.

(30) Priority: **07.08.79 JP 100894/79**

(43) Date of publication of application:
**18.03.81 Bulletin 81/11**

(45) Publication of the grant of the patent:
**20.06.84 Bulletin 84/25**

(84) Designated Contracting States:
**DE FR GB**

(56) References cited:
**FR - A - 2 205 708**
**US - A - 4 122 549**

**IBM TECHNICAL DISCLOSURE BULLETIN, vol.
18, no. 9, February 1976, pages 2818-2819 New
York, U.S.A. H. SCHETTLER: "Bipolar bootstrap
circuit"**

(73) Proprietor: **NEC CORPORATION**
**33-1, Shiba 5-chome, Minato-ku**
**Tokyo 108 (JP)**

(72) Inventor: **Nagami, Akira**
**c/o Nippon Electric Co, Ltd. 33-1 Shiba Gochome**
**Tokyo (JP)**

(74) Representative: **Pears, David Ashley et al,**
**REDDIE & GROSE 16 Theobalds Road**
**London WC1X 8PL (GB)**

Courier Press, Leamington Spa, England.

## Description

The present invention relates to a semiconductor refresh circuit comprising a first terminal to which a first potential is applied, a second terminal to which a second potential is applied, a first signal node to which a first logical signal is applied, a second signal node, a control node to which refresh timing signals are applied via a capacitor, a first field effect transistor coupled between said second terminal and second signal node and having a gate receiving a logic signal of the same phase as that at said first signal node, said first transistor generating at said second signal node a logic signal of an opposite phase to that at said first signal node, a second field effect transistor coupled between said second signal node and said first terminal and having a gate coupled to said control node and a control circuit for making said second transistor conduct thereby to supply said second node with said first potential.

At present the commonest dynamic random access memory (hereinafter abbreviated as RAM) is of the 2-clock, multi-address input type, e.g. as detailed in United States Patent No 3,969,706). Currently RAM's of 4K, 16K and 64K bits packaged in a standard 16-pin package are being produced, and future developments of 256K and 1M bit RAM's packaged in 16-pin packages are expected. The two clocks are normally called RAS (Row Address Strobe) and CAS (Column Address Strobe). RAS contributes to activation of an X-address inverter buffer, an X-decoder (row) buffer and a memory cell sense amplifier, while CAS contributes to activation of a Y-address (column) inverter buffer, a Y-decoder buffer and a data input/output bus amplifier and also effects control of the output state.

In a RAM of this system, an operation called RAS ONLY REFRESH can be effected, in which refresh is achieved by activating only RAS while maintaining CAS at a high level, that is, in a reset condition. In addition, it is possible to achieve an operation called HIDDEN REFRESH, in which after output data have been derived in a normal read cycle, only RAS is reset while maintaining CAS intact at a low level, that is, in an activated condition. Subsequently activations of the RAS are repeated, and thus refresh can be achieved with maintaining the output data intact.

However, a problem which occurs in both of these operation modes is that of maintaining a logic level in an output system for a long period of time. Since the maintaining of a logic level is basically achieved by making use of electric charge on an electrostatic capacitance, the level will be attenuated with time, and hence it has been difficult to maintain a logic level in an output system over a relative long period.

A circuit according to the present invention is characterised in that said control circuit includes a third field transistor adapted to provide an electrical path between said first terminal and said control node in response to a logic signal of the same phase as that at said second node and a fourth field effect transistor adapted to provide an electrical path between said control node and said second terminal in response to a logic signal of the same phase as that at said first signal node.

The present invention obviates the above-mentioned problems in a level refresh circuit in a CAS system circuit controlled by RAS system timing, during the RAS ONLY REFRESH and the HIDDEN REFRESH employed in the heretofore known RAM's of the 2-clock, multi-address input type.

Advantageous developments of the invention are defined in the dependent claims.

The invention will now be described in more detail, by way of example, with reference to the accompanying drawings in which:

Figure 1 is a timing chart showing, at (A), (B) and (C), three different operation modes in a RAM of the multi-strobe system, in which level refresh is effectively achieved by means of clocks,

Figures 2 and 3 are circuit diagrams respectively showing examples of the level refresh circuit in the prior art,

Figure 4 is a schematic circuit diagram showing a basic circuit construction of a semiconductor circuit for use in the present invention,

Figure 5 is a waveform diagram showing waveforms appearing at various points in Figure 4,

Figure 6 is a circuit diagram showing one preferred embodiment of the present invention,

Figure 7 is a waveform diagram showing waveforms appearing at various points in Figure 6,

Figure 8 is a circuit diagram showing another preferred embodiment of the present invention, and

Figure 9 is a waveform diagram showing waveforms appearing at various points in Figure 8.

The following description of the present invention is given, by way of example, with respect to the case where MOS transistors (hereinafter abbreviated as MOST) are used, since they are representative among insulated gate field effect transistors. In particular N-channel MOST's are employed, and it is assumed that a high level is a logic "1" level and a low level is a logic "0" level. However, with regard to the circuit structure, the subject semiconductor circuit is essentially the same if employing P-channel MOST's.

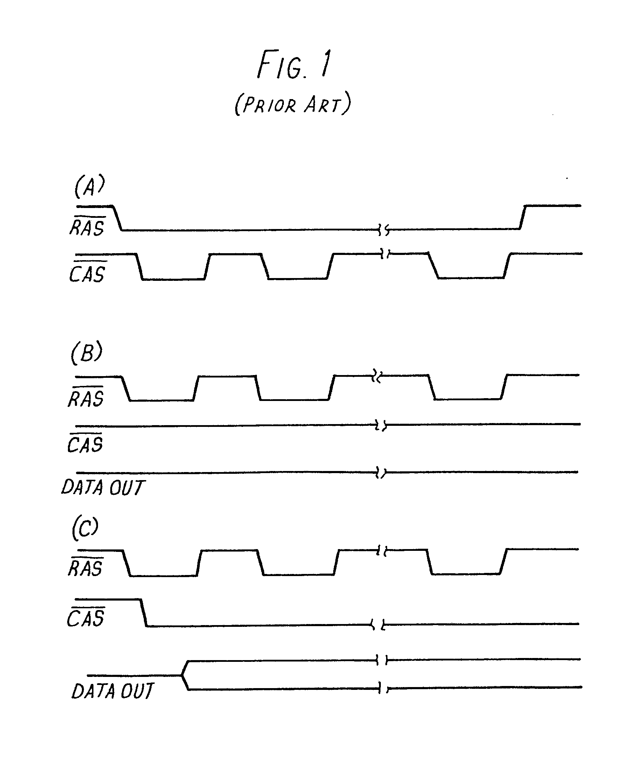

According to the known multi-strobe system, three types of inherent operation modes are provided depending upon the method used for inputting RAS and CAS, as shown in Figure 1. In a page mode shown at (A) in Figure 1, CAS is activated a plurality of times while RAS is maintained in an activated condition, and with respect to the memory cells on the selected word lines, a read cycle, a write cycle and a read modify write cycle can be effected within a cycle time shorter than the normal operation cycle. The operation modes shown at (B) and (C) in Figure 1 both belong to a refresh cycle, and in the $\overline{RAS}$ ONLY REFRESH shown at (B), refresh can be achieved by activating only $\overline{RAS}$ while maintaining the $\overline{CAS}$ at the high level, that is, in a reset condition. At this time, the output is maintained in a high impedance condition, hence it is adapted to an OR construction of outputs in practical use, and the distinction between an activated operation cycle and a refresh cycle can be controlled by $\overline{CAS}$. In the HIDDEN REFRESH shown at (C), after output data have been derived in a normal read cycle, only $\overline{RAS}$ is reset while maintaining $\overline{CAS}$ intact in the activated condition, that is, at the low-level, and subsequently when activations of $\overline{RAS}$ are repeated, refresh can be effected and also the output data can be maintained intact to be effectively utilized. The problem occurring in common to these three operation modes is to maintain a logic level for a long period of time, and the practical problem in each operation mode is as follows:

(A) Page mode:

It is necessary to maintain the last condition of the activation operation of $\overline{RAS}$ during the interval of the activation period of $\overline{RAS}$. The rated value is normally 10 uS at the maximum.

(B) RAS ONLY REFRESH:

The reset-precharge condition of $\overline{CAS}$ must be maintained during this refresh period. While there exists only the limitation that the $\overline{RAS}$ should be activated during the refresh period, normally at an interval of 2 mS, $\overline{CAS}$ is not limited in timing, but the level of the timing generated by the $\overline{CAS}$ clock during the reset-precharge period has to be maintained at the logic level over the $\overline{RAS}$ ONLY REFRESH period.

(C) HIDDEN REFRESH:

During the period when $\overline{CAS}$ is held at the low level, the output data level must be effectively maintained. In this case the circuit construction is such that when $\overline{RAS}$ is reset while $\overline{CAS}$ is maintained at the low level, a timing generated from $\overline{CAS}$ is also reset, and thereafter even if $\overline{RAS}$ repeats activations the timing is held in the reset condition. Accordingly, like the $\overline{RAS}$ ONLY REFRESH, the timing generated from $\overline{CAS}$ is required to hold the level in the reset-precharge period at the logic level throughout the HIDDEN REFRESH period.

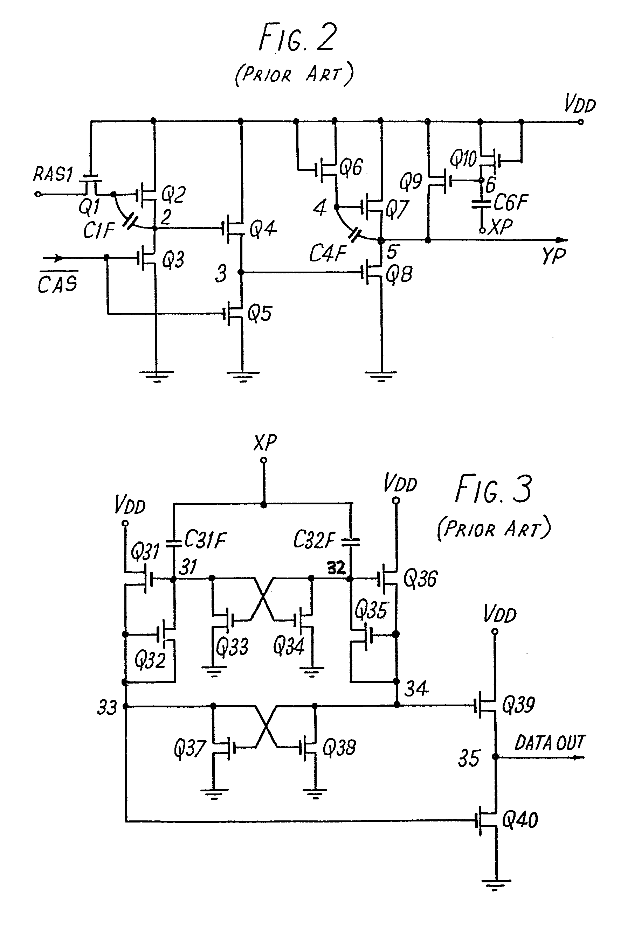

In the prior art, with regard to such maintenance of levels, at first in the operation mode (A) above, no provision is made with respect to the circuit but it is presupposed that the last condition of the activation operation such as the high level on the selected word line is maintained. The maintenance of the level in the reset-precharge condition of the timing generated from the $\overline{CAS}$ in the operation modes (B) and (C) above, can be achieved, for example, in the circuit shown in Figure 2.

Referring now to Figure 2, reference symbol YP designates a precharge system timing signal generated from $\overline{CAS}$, and the operation of the illustrated circuit is explained in the following. A timing signal RAS 1 is generated based on $\overline{RAS}$ and gated in through MOST Q1 to a node 1. When $\overline{CAS}$ changes from the low level to the high level, since a MOST $Q_3$ has a sufficiently larger current capability than a MOST $Q_2$ (with bootstrap capacitor C1F), a node 2 takes a low level lower than a threshold voltage of the transistors employed in this circuit. A MOST $Q_4$ thus becomes non-conducting, while a MOST $Q_5$ becomes conducting due to the high level of $\overline{CAS}$, so that a node 3 discharges to the ground potential. When a MOST $Q_8$ thus becomes non-conducting, a node 5, that is, the timing YP begins to rise through a MOST $Q_7$, and hence a node 4 rises up to the level of:

$$V_{DD}-\text{threshold voltage} +\frac{C_{4F}}{C_4+C_{4F}}\times V_5, \quad (1)$$

due to a bootstrap capacitor $C_{4F}$, and the MOST $Q_7$ is driven to a non-saturation region, so that the timing signal YP reaches the level $V_{DD}$ of the voltage source. In the above equation, $C_4$ represents a capacitance of the node 4 and $V_5$ represents a voltage at the node 5. In the periods of the $\overline{RAS}$ ONLY REFRESH and the HIDDEN REFRESH, the timing signal YP must be maintained intact at the level $V_{DD}$. MOST's $Q_9$ and $Q_{10}$ and a bootstrap capacitor $C_{6F}$ respond to the timing signal XP which rises during the reset-precharge period for acting to refresh the $V_{DD}$ level of the timing signal YP. In more particular, when the timing signal XP rises from the ground potential to the $V_{DD}$ level, a node 6 reaches the level of:

$$V_{DD}-\text{threshold voltage}+\frac{C_{6F}}{C_6+C_{6F}}\times V_{DD} \quad (2)$$

so that the MOST $Q_9$ is driven to an unsaturated region and thus refreshes the $V_{DD}$ level of the timing signal YP. In the above equation, $C_6$ represents a capacitance of the node 6. The node 6 takes the ($V_{DD}$—threshold voltage) level when $\overline{RAS}$ is at the low level, that is, during the activation period, whereas it takes the level represented by the equation (2) above when $\overline{RAS}$ is at the high level, that is, during the reset-precharge period. Accordingly the MOST $Q_9$ is always conducting, and hence during the period when the timing signal YP is at the low level, a D.C. current flows through the MOST's $Q_9$ and $Q_8$. Although the current capability of

the MOST $Q_9$ could be small, it is a shortcoming that there is a continuous current drain.

In connection to the maintenance of the output data level in the operation mode (C) above, a circuit shown in Figure 3 has been used. In this circuit, the state of a latch circuit including MOST's $Q_{37}$ and $Q_{38}$ is determined by true and complement signals derived from input/output buses (not shown) connected to nodes 33 and 34. The levels at the nodes 33 and 34 are transmitted to nodes 31 and 32 through MOST's $Q_{32}$ and $Q_{35}$ thereby to establish a state of a control latch circuit including MOST's $Q_{33}$ and $Q_{34}$. The levels at the nodes 31 and 32 control refresh operation on the nodes 33 and 34 as described later. MOST's $Q_{39}$ and $Q_{40}$ forms an output buffer in a push-pull manner.

In this figure, the node 33 and node 34 may be regarded as outputs of a data latch, where mutually complementary logic levels arise, and data is derived at a node 35, that is, at an output terminal DATA OUT. In the HIDDEN REFRESH, it is necessary to refresh the levels at the node 33 and at the node 34 by means of the $\overline{RAS}$ series clock. Considering the case where the data output buffer responds in such a manner that the node 34 rises from ground potential up to the $V_{DD}$ level, while the mode 33 is maintained at the ground potential, whereby a high level output is derived at the output terminal DATA OUT and the node 32 is charged up to the ($V_{DD}$—threshold voltage) level. Since the node 33 is maintained at the ground potential, the node 31 will not be charged up, and as the MOST $Q_{33}$ becomes conducting due to the potential rise at the node 32, the node 31 is still maintained at the ground potential. If $\overline{RAS}$ is reset while $\overline{CAS}$ is maintained at the low level, when the levels at the node 33 and at the node 34 are dynamically maintained intact, and hence, effective data is held at the output terminal DATA OUT. Until $\overline{CAS}$ is reset, this condition must be sustained, and therefore, MOST's $Q_{31}$ to $Q_{36}$ and bootstrap capacitors $k_{31F}$ and $C_{32F}$ have the function of refreshing the levels at the nodes 33 and 34 during this period in response to rise of a timing signal XP in the reset-precharge period of the $\overline{RAS}$. When the timing signal XP rises from ground potential to the $V_{DD}$ level, the node 32 rise up to the level of:

$$V_{DD}\text{—threshold voltage}+\frac{C_{32F}}{C_{32}+C_{32F}}\times V_{DD} \quad (3)$$

due to the bootstrap capacitor $C_{32F}$, so that the MOST $Q_{36}$ is driven to an unsaturated region and thereby refreshes the node 34 at the $V_{DD}$ level. In the above formula, $C_{32}$ represents a capacitance at the node 32. On the other hand, in response to the rise of the timing signal XP, the node 31 also tends to rise due to the boot-strap capacitor $C_{31F}$, but since the MOST $Q_{33}$ is conducting due to the high level at the node 32,

the MOST $Q_{33}$ acts to suppress the rise of the node 31. When the node 34 has been refreshed to the $V_{DD}$ level, the node 33 is refreshed to the ground potential through the MOST $Q_{37}$. In contrast to the above-described case, when the node 34 is at the low level and the output terminal derives low level data also, the operation of the circuit can be explained in a similar manner. As described above, if activations of $\overline{RAS}$ are repeated while $\overline{CAS}$ is maintained at the low level, then level refresh at the node 33 and at the node 34 is effected in the reset-pre-charge period of the $\overline{RAS}$.

In the above-described circuit construction, there can occur the problem that, when the node 34 is at the high level, if the charging of the node 32 through the MOST $Q_{35}$ is not perfect, when $\overline{RAS}$ is reset and the node 34 takes a high-impedance, high-level condition, the electric charge at the node 34 will partly transfer to the node 32 through the MOST $Q_{35}$, and thereby the level at the node 34 will be lowered. This problem becomes especially significant when the period from the time when $\overline{CAS}$ has been activated and data have been derived at the output terminal DATA OUT until $\overline{RAS}$ is reset, is short, resulting in level lowering of the high-level data at the output terminal.

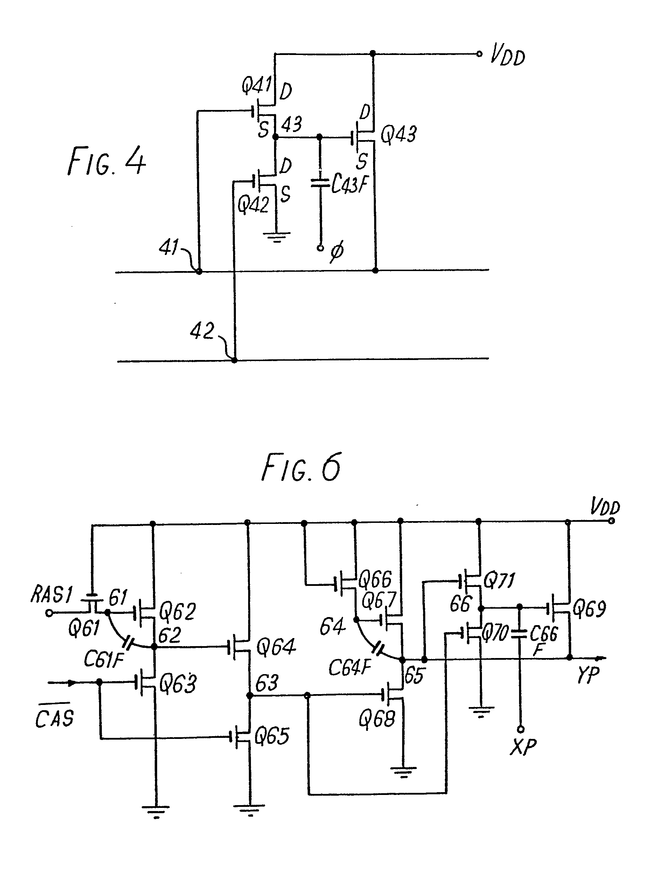

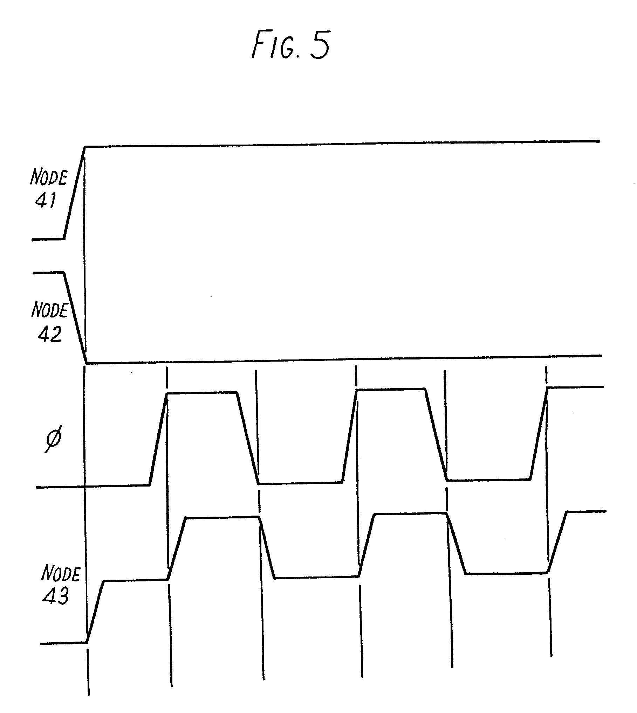

A basic circuit construction for use in the present invention is illustrated in Figure 4, and operation waveforms appearing at various points in Figure 4 are shown in Figure 5. The letters S and D denote source and drain electrodes.

In Figure 4, a node 41 and a node 42 have mutually complementary logic levels, and the established levels are dynamically maintained for making the nodes high impedance. Considering the case in which the node 41 changes from ground potential to the $V_{DD}$ level, in the initial condition since a MOST $Q_{41}$ is non-conduct-ing and a MOST $Q_{42}$ is conducting, a node 43 is held at ground potential. In response to the rise of the node 41, the node 43 is charged up through the MOST $Q_{41}$, and eventually reaches the ($V_{DD}$—threshold voltage) level. During the period when the node 41 is held at the $V_{DD}$ level and the node 42 is held at the ground potential, if it is assumed that a clock $\phi$ is activated so as to rise from ground potential to the $V_{DD}$ level, then the node 43 is raised up to the level of:

$$V_{DD}\text{—threshold voltage}+\frac{C_{43F}}{C_{43}+C_{43F}}\times V_{DD} \quad (4)$$

due to a bootstrap capacitor $C_{43F}$, $C_{43}$ being the capacitance at node 43. As a result, a MOST $Q_{43}$ is driven to an unsaturated region and acts upon the node 41 so as to charge the node 41 up to the $V_{DD}$ level, and thus level refresh of the node 41 is effected. In accordance with the subsequent level changes of the clock $\phi$, the node 43 is held at the ($V_{DD}$—threshold voltage) level during the period when the clock $\phi$ is at

the low level, while it is held at the level represented by the equation (4) above during the period when the clock $\phi$ is at the high level, and while the clock is held at the high level, level refresh of the node 41 is repeated. These operations are illustrated in Figure 5. When the node 41 changes to the low level and the node 42 changes to the high level, the MOST $Q_{41}$ becomes non-conducting, while the MOST $Q_{42}$ becomes conducting, so that the node 43 changes to ground potential and the MOST $Q_{43}$ becomes non-conducting. As described above, the MOST's $Q_{41}$ to $Q_{43}$, and the bootstrap capacitor $C_{43F}$ have the sole function of refreshing the high level equal to $V_{DD}$ at the node 41 in response to the clock $\phi$. In the circuit shown in Figure 4, only the node 41 is subjected to the level refresh and hence the refresh circuit including MOST's $Q_{41}$ to $Q_{43}$ and the capacitor $C_{43F}$ is provided for the node 41. If the node 42 is also required to be refreshed in level, the same refresh circuit is provided for the node 42.

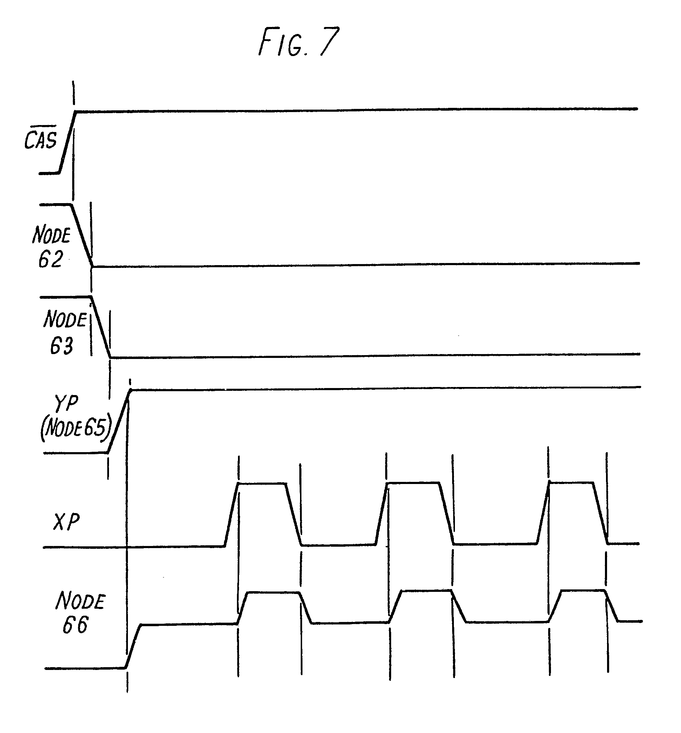

Practical applications of the present invention will be explained in the form of applying the present invention to the known circuits shown in Figures 2 and 3. A semiconductor circuit according to the present invention as applied to a timing generator circuit for the $\overline{CAS}$ system precharge timing signal YP, as illustrated in Figure 6 and operation waveforms appearing at various points in the illustrated circuit are shown in Figure 7. Reference numerals 61 to 69 correspond to reference numerals 1 to 9 of Figure 2.

The operations up to the time point when $\overline{CAS}$ changes from the low level to the high level, thus entering into the reset-precharge period and the timing signal YP rises up to $V_{DD}$, are just as described previously. In response to the rise of the timing signal YP, the node 66 is charged up through a MOST $Q_{71}$ and rises to the ($V_{DD}$—threshold voltage) level. It is to be noted that the node 63 has been brought to the ground potential prior to the rise of the timing signal YP, and thus a MOST $Q_{70}$ is non-conducting. During the reset-precharge period of $\overline{CAS}$, if activations of the $\overline{RAS}$ are repeated, then in response to the rise of the timing signal XP in the reset-precharge period of $\overline{RAS}$, the node 66 rises up to the level of:

$$V_{DD}\text{—threshold voltage} + \frac{C_{66F}}{C_{66}+C_{66F}} \times V_{DD} \quad (5)$$

due to a bootstrap capacitor $C_{66F}$. In the above formula, $C_{66}$ represents a capacitance of the node 66, and the timing signal XP takes the potential $V_{DD}$ at its high level and the ground potential at its low level. The MOST $Q_{69}$ is driven to an unsaturated region and thereby refreshes the $V_{DD}$ level of the timing signal YP. The node 66 takes the ($V_{DD}$—threshold voltage) level when the timing signal XP is at the low level, while it takes the level represented by the equation (5) when the timing signal XP is at the high level, and the $V_{DD}$ level refresh of the timing signal YP is repeated when the timing signal XP becomes the high level, as illustrated in Figure 7. Thereafter, when $\overline{CAS}$ changes from the high level to the low level, since $\overline{RAS}$ is always activated prior to $\overline{CAS}$, an activation timing $\overline{RAS}$ 1 in the $\overline{RAS}$ system has been already raised to the $V_{DD}$ level, hence the node 62 rises at first up to the $V_{DD}$ level, and subsequently the node 63 rises up to the ($V_{DD}$—threshold voltage) level. The MOST $Q_{68}$ has a sufficiently larger current capability than the MOST $Q_{67}$, and hence, the timing signal YP changes to the low level which is sufficiently lower than the threshold voltage. Accordingly, the MOST $Q_{71}$ becomes nonconducting, while the MOST $Q_{70}$ becomes conducting, and the node 66 is brought to ground potential. Since the MOST $Q_{69}$ becomes non-conducting, no D.C. current will flow through the level refresh circuit as is the case with the known circuit shown in Figure 2.

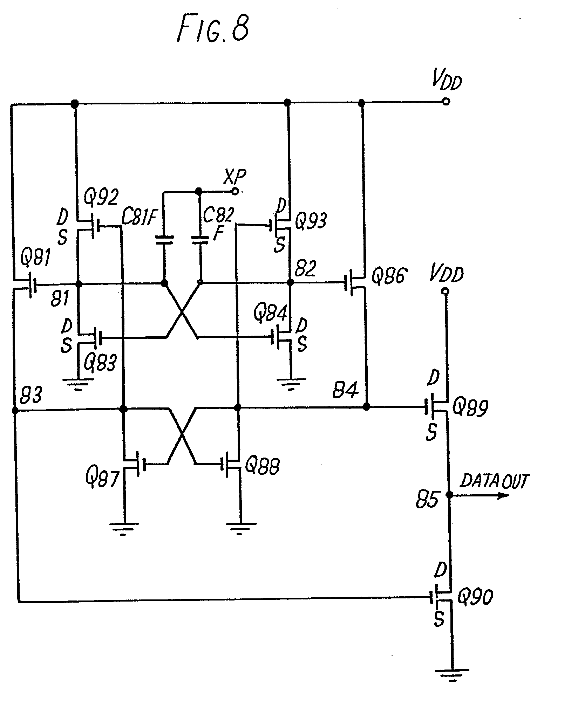

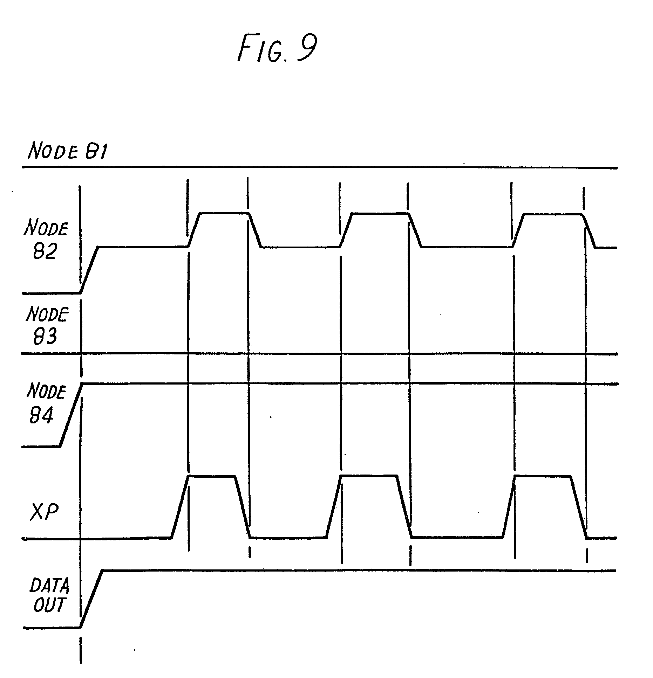

Next, a semiconductor circuit according to the present invention as applied to an output circuit section shown in Figure 3, is illustrated in Figure 8, and operation waveforms appearing at various points in Figure 8 are shown in Figure 9. Reference numerals in the range 81 to 90 correspond to 31 to 40 in Figure 3.

Assume that the node 83 and node 84 have both been reset to ground potential and consider the case in which the node 84 rises up to the $V_{DD}$ level while the node 83 stays at ground potential. Accordingly high level data appear at the output terminal consisting of the node 85. In response to the rise of the node 84, the node 82 is charged up to the ($V_{DD}$—threshold voltage) level through a MOST $Q_{93}$. Consequently, the MOST $Q_{83}$ becomes conducting, and since a MOST $Q_{92}$ is non-conducting, the node 81 is brought to ground potential. During the period when this condition sustains, if the $\overline{RAS}$ system precharge timing signal XP is activated, the node 82 rises up to the level of:

$$V_{DD}\text{—threshold voltage} + \frac{C_{isF}}{C_{82}+C_{82F}} \times V_{DD} \quad (6)$$

due to a bootstrap capacitor $C_{82F}$. In the above formula, $C_{82}$ represents the capacitance of the node 82 and it is assumed that the timing signal XP changes from ground potential to the $V_{DD}$ level. Thus the MOST $Q_{86}$ is driven to an unsaturated region and the $V_{DD}$ level at the node 84 can be refreshed. The node 82 takes the ($V_{dd}$—threshold voltage) level when the timing signal XP is at the low level, while it takes the level represented by equation (6) above when XP is high and the $V_{DD}$ level refresh of the node 84 is repeated each time the timing signal XP takes the high level, as shown in Figure 9. Although the node 81 also tends to rise in response to the rise of the timing signal XP due to the bootstrap capacitor $C_{81F}$, the high level at the node 82 makes the MOST $Q_{83}$ conduct, and thus suppresses the rise of the node 81. In this case, the node 82 merely acts to refresh the $V_{DD}$ level at the node 84, and there is no possibility of it adversely affecting the level at the node 84 as is the case with the circuit shown in Figure 3.

As described in detail above, the circuit function of level refreshing with a clock at a node which has once risen up to the $V_{DD}$ level, can be provided without being accompanied by the shortcomings as appearing in the heretofore known circuits.

## Claims

1. A semiconductor refresh circuit comprising a first terminal to which a first potential ($V_{DD}$) is applied, a second terminal to which a second potential (Ground) is applied, a first signal node (63, 83) to which a first logic signal is applied, a second signal node (65, 84), a control node (66, 82) to which refresh timing signals (XP) are applied via a capacitor ($C66_F$, $C82_F$), a first field effect transistor (Q68, Q88) coupled between said second terminal and second signal node and having a gate receiving a logic signal of the same phase as that at said first signal node, said first transistor generating at said second signal node a logic signal of an opposite phase to that at said first signal node, a second field effect transistor (Q69, Q86) coupled between said second signal node and said first terminal and having a gate coupled to said control node and a control circuit for making said second transistor conduct thereby to supply said second node with said first potential, characterised in that said control circuit includes a third field effect transistor (Q71, Q93), adapted to provide an electrical path between said first terminal and said control node in response to a logic signal of the same phase as that at said second node and a fourth field effect transistor (Q70, Q84) adapted to provide an electrical path between said control node and said second terminal in response to a logic signal of the same phase as that at said first signal node.

2. A circuit according to claim 1, characterised by further comprising an output circuit including fifth (Q89) and sixth (Q90) field effect transistors adapted to operate in a push-pull manner in response to said first and second logic signals.

3. A circuit according to claim 1, characterised by further comprising a boot-strap type load circuit (Q66, Q67, C64F) coupled between said first terminal and said second signal node.

4. A circuit according to claim 1, characterised by further comprising a first additional transistor (Q87) forming a first flip-flop together with said first field effect transistor and a second additional transistor (Q83) forming a second flip-flop together with said fourth transistor.

## Patentansprüche

1. Halbleiterrefresh-Schaltung mit einem ersten Anschluß für eine erste Spannung ($V_{DD}$), einem zweiten Anschluß für eine zweite Spannung (Masse), einem ersten Schaltungspunkt (63, 83) zum Anlegen eines ersten Logiksignals, einem zweiten Schaltungspunkt (65, 84), einem Steuersignalknoten (66, 82) zum Anlegen von Refreshtaktsignalen (XP) über einen Kondensator ($C66_F$, $C82_F$), einem ersten Feldeffekttransistor (Q68, Q88), der zwischen dem zweiten Anschluß und dem zweiten Schaltungspunkt liegt und an dessen Gate ein Logiksignal anliegt, das gleichphasig mit dem am ersten Schaltungspunkt ist, so daß der erste Feldeffekttransistor am zweiten Schaltungspunkt ein zum Logiksignal am ersten Schaltungspunkt gegenphasiges Logiksignal erzeugt, einem zweiten Feldeffekttransistor (Q69, Q86), der zwischen dem zweiten Schaltungspunkt und dem ersten Anschluß und mit seinem Gate am Steuersignalknoten liegt, und mit einer Kontrollschaltung zum Durchschalten des zweiten Transistors, um die erste Spannung an den zweiten Schaltungspunkt zu legen, dadurch gekennzeichnet, daß die Kontrollschaltung einen dritten Feldeffekttransistor (Q71, Q93) aufweist, der in Abhängigkeit von einem Logiksignal, des gleichphasig mit dem am zweiten Schaltungspunkt ist, eine leitende Verbindung zwischen dem ersten Anschluß und dem Steuersignalknoten herstellt, und daß die Kontrollschallung einen vierten Feldeffekttransistor (Q70, Q84) aufweist, der in Abhängigkeit von einem Logiksignal, das gleichphasig mit dem am ersten Schaltungspunkt ist, eine leitende Verbindung zwischen dem Steuersignalknoten und dem zweiten Anschluß herstellt.

2. Schaltung nach Anspruch 1, dadurch gekennzeichnet, daß eine Ausgangsschaltung einen fünften (Q89) und sechsten (Q90) Feldeffekttransistor aufweist, die in Abhängigkeit vom ersten und zweiten Logiksignal im Gegentakt betrieben werden.

3. Schaltung nach Anspruch 1, dadurch gekennzeichnet, daß eine Bootstrap-Schaltung (Q66, Q67, $C64_F$) als Last zwischen dem ersten Anschluß und dem zweiten Schaltungspunkt liegt.

4. Schaltung nach Anspruch 1, dadurch gekennzeichnet, daß ein erster zusätzlicher Transistor (Q87) gemeinsam mit dem ersten Feldeffekttransistor eine erste Flip-Flop-Schaltung bildet und daß ein zweiter zusätzlicher Transistor (Q83) gemeinsam mit dem vierten Transistor eine zweite Flip-Flop-Schaltung bildet.

## Revendications

1. Circuit de régénération à semi-conducteur comprenant une première borne à laquelle est appliqué un premier potentiel ($V_{DD}$), une seconde borne à laquelle est appliqué un second potentiel (masse), un premier noeud de signal (63, 83) auquel est appliqué un premier signal logique, un second noeud de signal (65, 84), un noeud de commande (66, 82) auquel sont appliqués via un condensateur ($C66_F$, $C82_F$) des signaux de synchronisation de régénération (XP), un premier transistor à effet de champ (Q68, Q88) branché entre la seconde borne et le second noeud de signal et ayant une porte recevant un signal logique ayant la même phase que celui présent au premier noeud de signal, ce premier transistor produisant au second noeud de signal un signal logique ayant une phase opposée à celui présent au premier noeud de signal, un second transistor à effet de champ (Q69, Q86) branché entre le second noeud de signal et la première borne et ayant une porte couplée au noeud de commande et un circuit de commande pour rendre le second transistor conducteur, d'où il résulte la fourniture au second noeud d'un premier potentiel, caractérisé en ce que ce circuit de commande comprend un troisième transistor à effet de champ (Q71, Q93) destiné à fournir un trajet électrique entre la première borne et le noeud de commande en réponse à un signal logique de la même phase que celui présent au second noeud et un quatrième transistor à effet de champ (Q70, Q84) destiné à fournir un trajet électrique entre le noeud de commande et la seconde borne en réponse à un signal logique ayant la même phase que celui présent au premier noeud de signal.

2. Circuit selon la revendication 1, caractérisé en ce qu'il comprend en outre un circuit de sortie comportant des cinquième (Q89) et sixième (Q90) transistors à effet de champ destinés à fonctionner à la façon push-pull en réponse aux premier et second signaux logiques.

3. Circuit selon la revendication 1, caractérisé en ce qu'il comprend en outre un circuit de charge du type amplificateur à contre-réaction positive (Q66, Q67, C64F) branché entre la première borne et le second noeud de signal.

4. Circuit selon la revendication 1, caractérisé en ce qu'il comprend en outre un premier transistor supplémentaire (Q87) formant une première bascule avec le premier transistor à effet de champ et un second transistor supplémentaire (Q83) formant une seconde bascule avec le quatrième transistor.

# $F$ IG. 1

## (PRIOR ART)

(A)

$\overline{RAS}$

$\overline{CAS}$

(B)

$\overline{RAS}$

$\overline{CAS}$

DATA OUT

(C)

$\overline{RAS}$

$\overline{CAS}$

DATA OUT

FIG. 2
(PRIOR ART)

FIG. 3
(PRIOR ART)

FIG. 4

FIG. 6

*FIG. 5*

NODE
41

NODE
42

ɸ

NODE
43

FIG. 7

# FIG. 8

# FIG. 9

NODE 81

NODE 82

NODE 83

NODE 84

XP

DATA OUT